# EUROPEAN PATENT APPLICATION

(11) **EP 4 787 418 A1**
(43) Date of publication of application: **05.08.2026**
(21) Application number: 25155595.9
(22) Date of filing: 03.02.2025
(51) Int. Cl.: H01J 37/22, H01J 37/28, H01J 37/26

(54) **OPTICAL ASSEMBLY**

(71) Applicant: ASML Netherlands B.V., 5500 AH Veldhoven (NL)
(72) Inventor: SCHEFFERS, Paul, IJmert, 5500 AH Veldhoven (NL); BASTIAANS, Koen, Mathijs, 5500 AH Veldhoven (NL); OVERES, Frank, Theo, 5500 AH Veldhoven (NL); DEL TIN, Laura, 5500 AH Veldhoven (NL); KONING, Johan, Joost, 5500 AH Veldhoven (NL)
(74) Representative: ASML Netherlands B.V.

(57) **Abstract**

The present disclosure describes an optical assembly for a charged particle-optical device configured to project one or more charged particle beams towards a sample, wherein the optical assembly comprises: a charged particle-optical element configured for passage of the one or more charged particle beams; detector element for detecting charged particles emitted from the sample in relation to the one or more charged particle beams; an optical element configured to project optical radiation towards the sample, wherein the optical element is configured to be positioned between the charged particle-optical element and the detector element and is further configured to be directly attached by adhesive to the charged particle-optical element or the detector element.

## Description

### FIELD

The present invention relates to an optical assembly, an optical component a charged particle optical device, an assessment apparatus and a method.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

When the primary beam scans the sample, charges may be accumulated on the sample due to large beam current, which may affect the quality of the image. There is therefore a need to improve the defect contrast during defect inspection.

There are challenges in the provision of components which provide such contrast, in particular, in relation to incorporation of the relevant components within charged particle systems.

### SUMMARY

According to an aspect of the present invention, there is provided an optical assembly for a charged particle-optical device configured to project one or more charged particle beams towards a sample, wherein the optical assembly comprises: a charged particle-optical element configured for passage of the one or more charged particle beams; a detector element for detecting charged particles emitted from the sample in relation to the one or more charged particle beams; an optical element configured to project optical radiation towards the sample, wherein the optical element is configured to be positioned between the charged particle-optical element and the detector element and is further configured to be directly attached by adhesive to the charged particle-optical element or the detector element.

According to an aspect of the present invention, there is provided an optical component for a charged particle-optical device configured to project one or more charged particle beams towards a sample, wherein the optical component comprises: an optical element configured to project optical radiation towards the sample, wherein the optical element comprises a coupling surface; and a waveguide array comprising a coupling surface, wherein the waveguide array is optically coupled to the optical element via the coupling surfaces, and wherein optical element and the waveguide array are connected, directly or indirectly, to define a gap between the coupling surfaces.

According to an aspect of the present invention, there is provided a method of providing an optical assembly as described herein, wherein the method comprises: attaching directly the optical element to the charged particle-optical element; and attaching the detector element to the assembly, wherein the optical element is positioned between the detector element and the charged particle-optical element.

According to an aspect of the present invention, there is provided a method of providing an optical assembly as described herein, wherein the method comprising: attaching the waveguide array to the optical element; then attaching the optical element to the charged particle-optical element; and attaching the detector element to the assembly, wherein the optical element is positioned between the detector element and the charged particle-optical element.

According to an aspect of the present invention, there is provided a charged particle optical device configured to project one or more charged particle beams towards a sample, the charged particle-optical device comprising an optical assembly as described herein and/or an optical component as described herein.

According to an aspect of the present invention, there is provided an assessment apparatus for inspecting the sample, comprising the charged particle-optical device as described herein.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts an alternative multi-beam charged particle-optical device, for example of the assessment apparatus of Figure 1;
- Figure 7 schematically depicts part of the multi-beam charged particle-optical device of Figure 6;
- Figure 8 schematically depicts a detector array in plan view;
- Figure 9 schematically depicts a detector element in cross-section;
- Figure 10 schematically depicts a cross section of an assembly for a charged particle-optical device, for example, of the type shown in figure 3 or figure 4;
- Figure 11 schematically depicts an isometric view of the assembly of figure 10;
- Figure 12 schematically depicts a cross-section of an assembly for a charged particle-optical device, for example, of the type shown in figure 3 or figure 4;
- Figure 13 schematically depicts an isometric view of the assembly of figure 12; and
- Figure 14 schematically depicts a cross-section of an assembly for charged particle-optical device, for example, of the type shown in figure 3 or figure 4.
- Figure 15 schematically depicts a cross-section of an assembly for charged particle-optical device, for example, of the type shown in figure 3 or 4.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

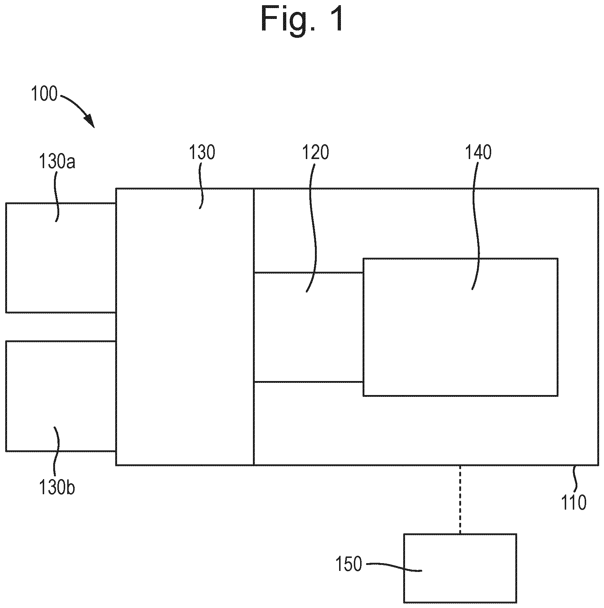

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus. The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

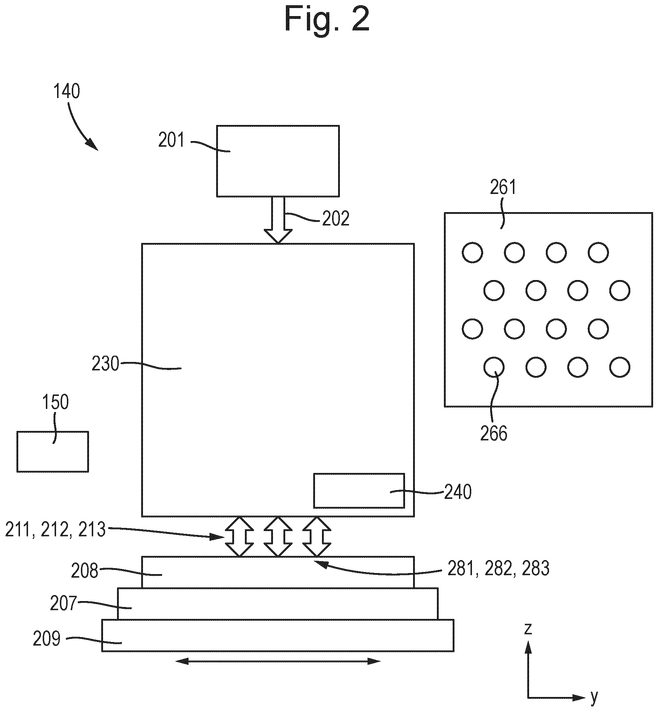

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

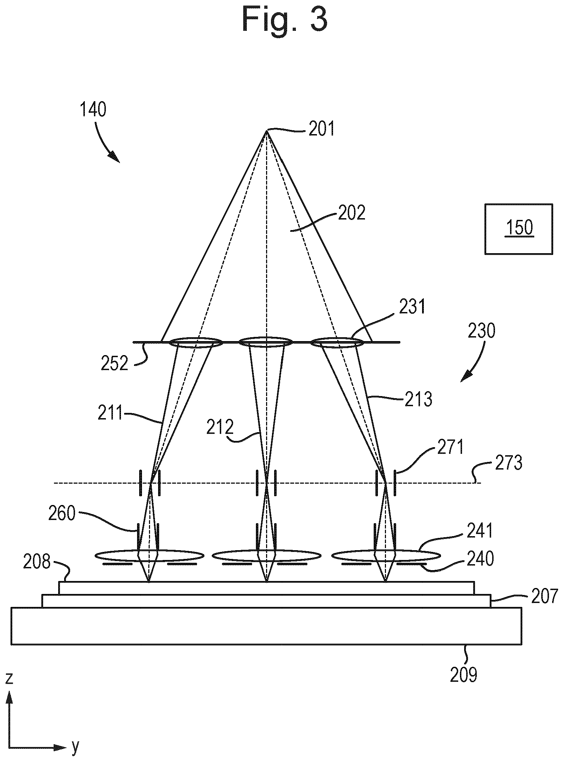

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

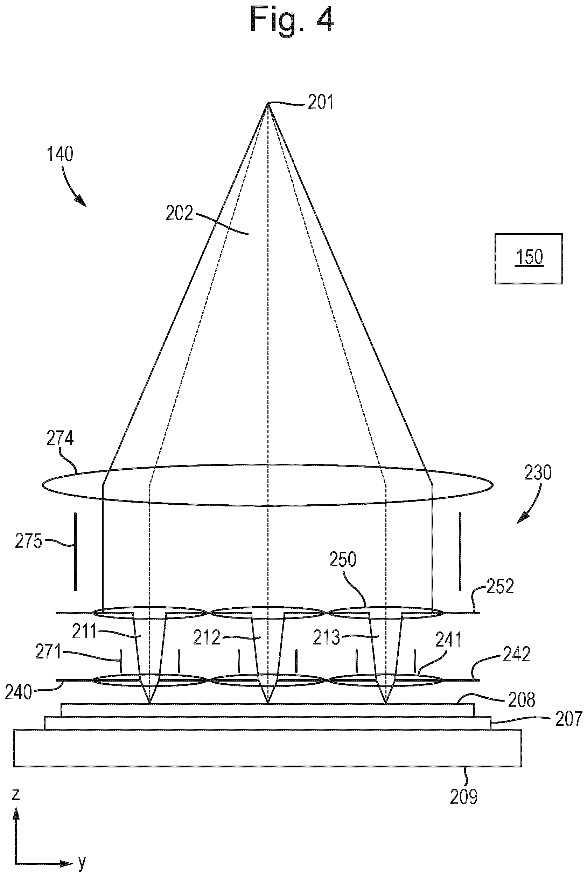

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

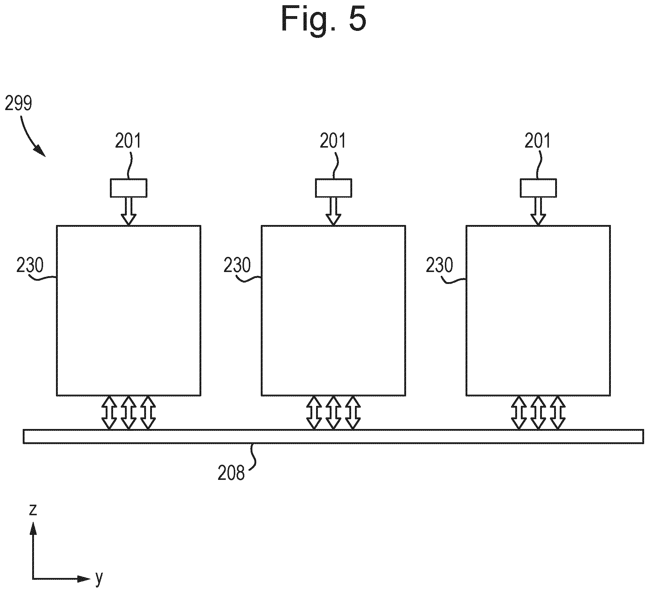

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

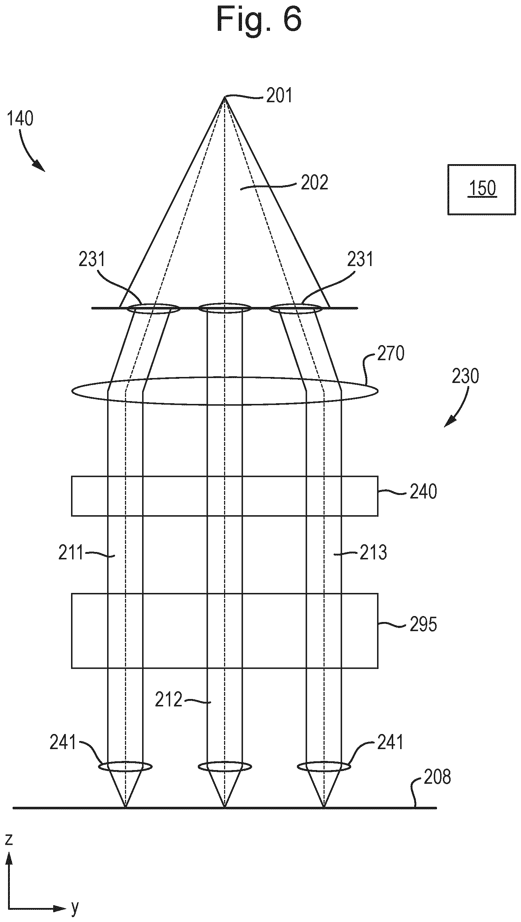

Figure 6 schematically depicts an electron-optical apparatus 140 of an assessment apparatus, e.g. the assessment apparatus 100 of Figure 1. The electron-optical apparatus 140 may be the electron-optical apparatus 140 of Figure 2 in which the electron-optical device 230 comprises a condenser lens array 231, a macro collimator 270, the detector array 240, a deflector array 295 and an objective lens array 241.

Features that are the same as those described above are given the same reference numerals. For conciseness, such features are not described in detail with reference to Figure 6. For example, the source 201, the condenser lens array 231, the objective lens array 241 and the sample 208 may be as described above.

The source is configured to generate a source beam 202. The condenser lens array 231 is configured to define a plurality of primary beams 211, 212, 213 from the source beam 202. The disclosure in EP1602121A1 of a lens array to split a beam into a plurality of beams, with the lens array providing a lens for each beam, is hereby incorporated by reference as a possible implementation of the condenser lens array 231.

In an embodiment the condenser lens array 231 comprises three plates 261 configured as an Einzel lens. An Einzel lens is configured to substantially ensure that the energy of an electron leaving the lens is the same as when the electron arrived at the lens. Such a lens maintains the energy of an electron between arriving and leaving the lens, for example the condenser lenses of the condenser lens array 231. Thus, dispersion only occurs within the condenser lens array 231 itself, thereby limiting chromatic aberrations. When a distance between the three plates of the Einzel lens is small, the chromatic aberrations caused by this condenser lens array 231 is limited, e.g. having a negligible effect.

In an embodiment the electron-optical device 230 comprises a collimator which may be macro collimator 270. The macro collimator 270 bends respective beams by an amount effective to ensure that a beam axis of each of the primary beams 211, 212, 213 derived from the primary 202 beam is incident on the sample 208 substantially normally (i.e. at substantially 90° to the nominal surface of the sample 208). In the current embodiment, the macro collimator 270 acts on all of the primary beams 211, 212, 213. The macro collimator 270 may comprise an electrostatic lens and/or a magnetic lens arrangement comprising a plurality of lens elements (e.g. a plurality of electrostatic and/or magnetic elements, e.g. forming a multipole).

In an embodiment the detector array 240 is configured to detect signal electrons by reference to the energy of the signal electron. For example, scintillators e.g. YAG do not directly detect electrons but generate light which is then detected. The signal electrons emitted from the sample 208 gain energy from the electromagnetic fields between the detector array 240 and the sample 208. In an embodiment, the objective lens array 241 is located between the detector array 240 and the sample 208.

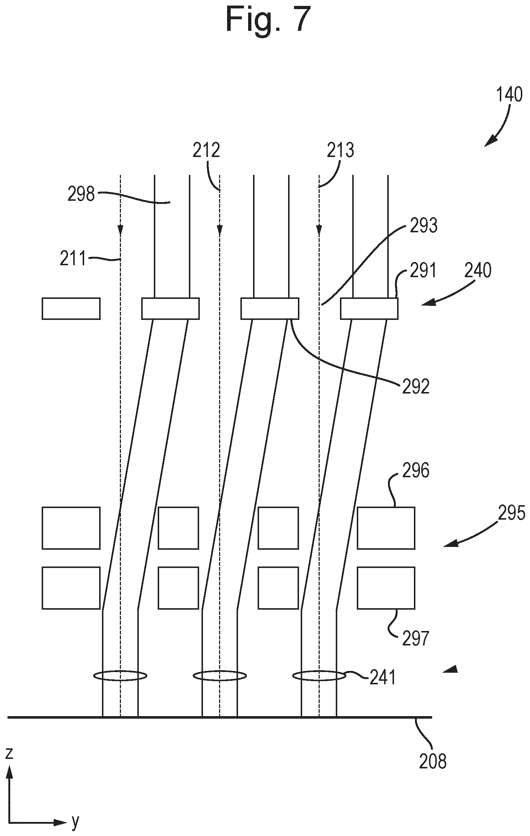

The electron-optical device 230 may comprise a deflector array 295 located between the detector array 240 and the objective lens array 241. The deflector array 295 may be referred to as a beam separator. The deflector array 295 may deflect signal electrons resulting from individual primary beams 211, 212, 213 along a path towards detector elements of a detector array 240 that is away from the paths of the primary beams towards the sample 208. The deflector array 295 may comprise a magnetic deflector array that is configured to provide magnetic fields to disentangle the primary electrons projected toward the sample 208 from the signal (e.g. secondary) electrons emitted from the sample 208. The deflector array 295 may comprise a Wien filter array. The deflector array 295 may comprise an electrostatic deflector array that is arranged to cooperate with the magnetic deflector array to achieve the disentangling of the paths of the primary electrons and signal electrons. Figure 7 is a close-up view of part of the electron-optical device 230 shown in Figure 6. In an embodiment the detector array 240 comprises an electron to photon converter array 291, e.g. a scintillator array. The electron to photon converter array 291 comprises a plurality of fluorescent elements (e.g. comprising YAG) which may be in the form of fluorescent strips 292 extending across the beam grid. Each fluorescent strip 292 is located in the plane of the electron to photon converter array 291. At least one fluorescent strip 292 is arranged between two adjacent primary beams 211, 212, 213 projected towards the sample 208. In an embodiment, the fluorescent strips 292 extend substantially across the beam grid. Alternatively, the electron to photon converter array 291 may comprise a plate of a fluorescent material with openings 293 for the primary beams 211, 212, 213 or an array of elements of similar size around the beams and that may be spaced apart. The primary beams 211, 212, 213 are projected through the plane of the electron to photon converter array 291, e.g. via the openings 293 such as between the fluorescent strips 292, towards the deflector array 295.

In an embodiment the deflector array 295 comprises a magnetic deflector 296 and an electrostatic deflector 297. The electrostatic deflector 297 is configured to counteract the deflection of the magnetic deflector 296 for the primary beams 211, 212, 213 transmitted towards the sample 208. Accordingly, the primary beams 211, 212, 213 may be shifted to a small extent in the horizontal plane. The beam paths downbeam of the deflector array 295 are substantially parallel to the beam paths upbeam of the deflector array 295.

In an embodiment the objective lens array 241 comprises a plurality of plates for guiding signal electrons emitted from the sample 208 towards the deflector array 295. For the signal electrons, which travel in opposite direction with respect to the projected primary beams 211, 212, 213, the electrostatic deflector 297 does not counteract the deflection of the magnetic deflector 296. Instead, the deflections of the secondary electrons by the electrostatic deflector 297 and the magnetic deflector 296 add up. Accordingly, the signal electrons are deflected to travel at an angle with respect to the optical axis in order to transmit the secondary electrons onto the fluorescent strips 292 of the detector array 240.

At the fluorescent strips 292, photons are created upon incidence of the signal electrons. In an embodiment, the photons are transported from the fluorescent strip 292 to a photo detector (not shown) via a photon transport unit. In an embodiment, the photon transport unit comprises an array of optical fibers 298. Each optical fiber 298 comprises an end which is arranged adjacent or attached to one of the fluorescent strips 292 for coupling photons from the fluorescent strip 292 into the optical fiber 298, and another end which is arranged to project photons from the optical fiber 298 onto the photo detector. In a different arrangement, the optical to electrical converter (or photo diode) is located immediately adjacent the electron to light converter, avoiding the need for optical fibers.

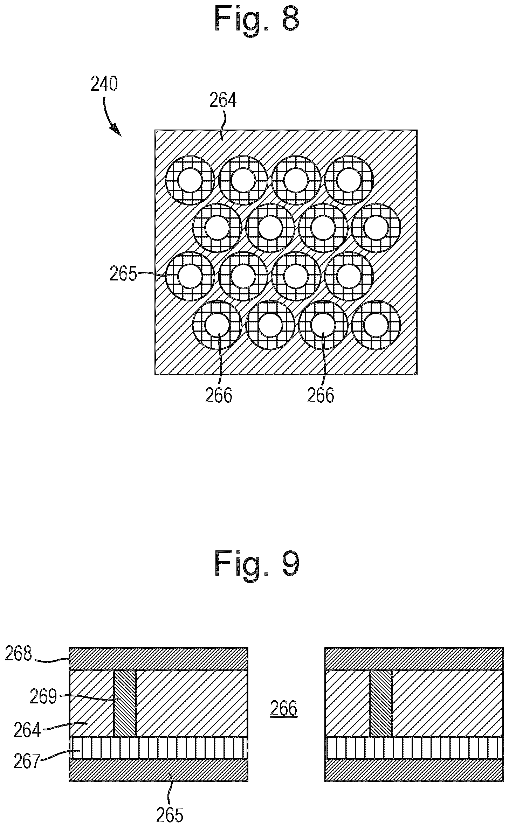

Figure 8 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 8, the beam apertures 266 are in a hexagonal close packed array. The beam apertures 266 can also be differently arranged, e.g. in a rectangular array.

Figure 9 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

In order to improve defect contrast during defect inspection, the sample 208 may be illuminated with optical radiation, for example light, before or during assessment of the sample with charged particles, for example electron beam(s). Voltage contrast-defect inspection, may be used to assess as to whether there is a proper electrical connection between a contact and a substrate of the sample 208. Depending on the signal electron yield (<1 or >1) the contact to the N+ or P+ doped region on the substrate forms a diode in reverse. As a result, it can be the case that it is not possible to distinguish between a proper and a bad electrical connection for either the N+ or the P+ contacts. By illuminating the sample 208 with light, the diode in reverse is made conductive. As a result, the contact will not charge in case there is a proper electrical connection between contact and substrate, but it will charge in case the electrical connection is bad. This technique of improving defect contrast by illuminating the sample with light, for example, during inspection of the sample is referred to as advanced charge control (ACC).

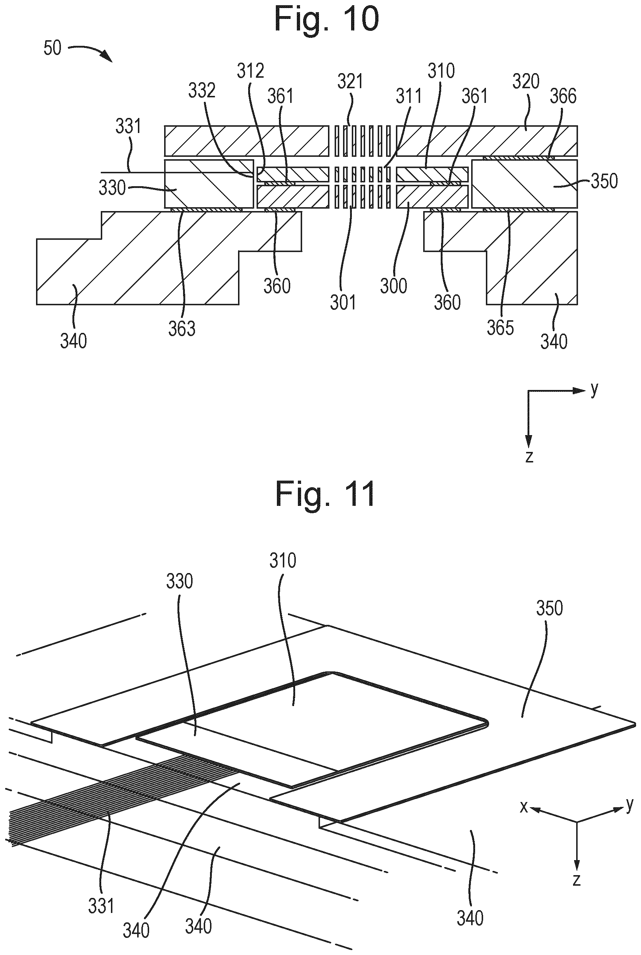

Figure 10 schematically depicts an assembly 50. The assembly may be part of an electron optical device 230. For example, the assembly 50 may be comprised in an electron-optical device 230 of the type shown in figure 3 or figure 4, for example. As another example, the assembly 50 may be comprised in an electron-optical device 230 that is configured to direct a single electron beam (rather than a plurality of electron beams) towards a sample 208. In other words, the assembly 50 may be used in either a single beam electron-optical apparatus 140 or a multi-beam electron optical apparatus 140 or any other type of multi-beam electron apparatus. The electron beam(s) may be directed along an electron-optical axis of the electron-optical device 230.

It is noted that the assembly 50 as shown in Figure 10 (and the following figures) may be provided in an electron-optical device 230 in an orientation other than shown. For example, the assembly 50 as shown in figures 10 onwards can be configured such that the detector 320 is proximal to and facing the sample or sample location 208 and is hence further down-beam from a charged particle-optical element 300. Details of the detector 320, the charged particle-optical element 300 and other components of the assembly 50 will be explained later in the description.

The axes shown in the figures are for reference only. The X-Y plane shown, for example in figures 10-15 is a 2D (two-dimensional) plane within which optical element 310 is defined. The Z axis is perpendicular/normal to 2D X-Y plane. Rz, Rx, Ry would be understood as rotation about Z, X and Y axes respectively.

The assembly 50 comprises charged particle-optical element 300 for passage of the one or more charged particle beams. The assembly 50 comprises detector element 320 for detecting charged particles emitted from the sample 208 in relation to the one or more charged particle beams. The assembly 50 comprises optical element 310 configured to project optical radiation towards the sample.

The optical element 310 may be part of an ACC module. The optical element 310 is configured to emit optical beams or optical radiation towards the sample 208. The optical element 310 is configured to illuminate the sample 208 with optical beams or optical radiation, for example, light. In one embodiment, the light can be in the visible wavelength range. In an embodiment, the optical element 310 is configured to emit the optical beams or optical radiation for improving defect contrast as described above.

The optical element 310 may be/may otherwise be referred to as an optical beam member, a photonics element, an integrated optics layer or circuit, and/or a photonics integrated chip (PIC).

In an embodiment the optical element 310 (e.g. the PIC) comprises at least one emitter. The emitter may be configured to emit the optical radiation towards the sample 208. For example, the optical element 310 may comprise internal mechanisms configured to couple optical radiation from an external element or source and direct the optical radiation towards the emitter for emission or out-coupling of the optical radiation towards the sample 208. The optical element 310 may be configured to receive optical radiation from an external element or component via a coupling surface 312.

The optical element 310 is adjacent to the charged particle-optical element 300 and the detector element 320. Thus, these elements can all be provided next to each other, as shown in figure 10, for example.

As shown in figure 10, the optical element 310 is located up-beam of the sample 208 (which would be at the top of figure 10). The optical element 310 is configured to be positioned between the charged particle-optical element 300 and the detector element 320. Thus, the optical element 310 can be positioned between the charged particle-optical element and the detector element 320, for example directly in-between - that is, sandwiched between the charged particle-optical element 300 and detector element 320, for example, with no other intermediate elements of the stack. In other words, the charged particle-optical element 300, the optical element 310 and the detector element 320 may be stacked in a specific order with the charged particle-optical element 300 up-beam of the optical element 310, and the optical element 310 up-beam of the detector element 320.

The optical element 310 is configured to be attached to the charged particle-optical element 300 - for example as shown in figure 10, the optical element 310 is configured to be directly attached by adhesive to the charged particle-optical element. Direct attachment by adhesive is beneficial in that this allows for improved/optimized alignment accuracy, and enables a less complex assembly flow in putting together the assembly. The optical element 310 and the charged particle-optical element 300 being directly attached means that the optical element 310 and the charged particle-optical element 300 are either in direct contact with each other and/or are separated by the attachment means. In the embodiment in Fig. 10, the optical element 310 and the charged particle-optical element 300 are adjacent to each other and are attached to each other without interim elements, i.e. without other optical elements being provided in between.

The optical element 310 is attached to the charged particle-optical element 300 by adhesive (i.e. which provides the attachment means). Any appropriate adhesive may be used. For example, the adhesive may be a UV curing adhesive.

The adhesive layer may be provided as a substantially planar adhesive layer 361. The planar adhesive layer 361 may be formed over at least part of the facing surfaces of the optical element 310 and the charged particle-optical element 300. The planar adhesive layer 361 may be provided as planar zones of adhesive 361, for example as shown in figure 10.

The adhesive may comprise spacer balls. A thickness of the adhesive layer 361 may be controlled, at least partially, by spacer balls. Thus, the spacing of adjacent, connected components may be set by the spacer balls. Thus, spacer balls may be beneficial in tuning the alignment, for example in the Z direction shown in figure 10 (or in other directions if the adhesive is used between other surfaces as shown in further figures). The spacer balls may have any appropriate diameter, for example the diameter of the spacer balls may be between 5 µm to 50 µm.

Each of the charged particle-optical element 300, the optical element 310 and the detector element 320 may define at least one aperture for the passage therethrough of the one or more charged particle beams and/or the said optical radiation as relevant. The at least one aperture in adjacent elements may be associated so as to allow for the passage of the one or more charged particle beams and/or the said optical radiation as relevant to pass through these elements in the assembly.

For example, the optical element 310 may define at least one aperture for the passage therethrough of the one or more charged particle beams. For example, the charged particle-optical element 300 may define at least one aperture for the passage therethrough of the one or more charged particle beams. The at least one aperture of the charged particle-optical element 300 may be associated with the at least one aperture of the optical element 310 for the passage of the one or more charged particle beams. Thus, at least part of the at least one aperture of the charged particle-optical element 300 may overlap in the X-Y plane with the at least one aperture of the optical element 310. More specifically, the at least one aperture of the charged-particle optical element 300 may be substantially aligned with the at least one aperture of the optical element 310. It will be understood that substantially aligned means the majority of the apertures overlap in the X-Y plane, however, during a practical implementation, there may be a small misalignment (e.g. of the order of micrometers). It will be understood that each of the at least one apertures referred to above may be an array of apertures, for example as shown in figure 10. In this case, each of the apertures in the array of apertures of the charged particle optical element 300 may be associated with, or more preferably substantially aligned with, one of the array of apertures of the optical element 310 as described above.

For example, the optical element 310 may define at least one aperture for the passage therethrough of the one or more charged particle beams. For example, the detector element 320 may define at least one aperture for the passage therethrough of the one or more charged particle beams and the optical radiation emitted by the optical element 310. The at least one aperture of the detector element 320 may be associated with the at least one aperture of the optical element 310 for the passage of the one or more charged particle beams. In other words, the at least one aperture in adjacent elements may be associated so as to allow for the passage of the one or more charged particle beams to pass through these elements in the assembly. Thus, at least part of the at least one aperture of the detector element 320 may overlap in the X-Y plane with the at least one aperture of the optical element 310. More specifically, the at least one aperture of the detector element 320 may be substantially aligned with the at least one aperture of the optical element 310. It will be understood that substantially aligned means the majority of the apertures overlap in the X-Y plane, however there may be a small misalignment (e.g. of the order of micrometers). It will be understood that each of the at least one apertures referred to above may be an array of apertures, for example as shown in figure 10. In this case, each of the apertures in the array of apertures of the detector element 320 may be associated with, or more preferably substantially aligned with, a respective one of the apertures in the array of apertures of the optical element 310 as described above.

Preferably, the at least one aperture (or the array of apertures) for each of the detector element 320, the optical element 310 and the charged particle-optical element are all associated, or preferably aligned, for example as shown in figure 10.

The assembly 50 may comprise a dielectric supporting structure 340 configured to support the charged particle-optical element 300. The dielectric supporting structure 340 may be configured to directly support the charged particle-optical element 300. The charged particle-optical element 300 may be attached to the dielectric supporting structure 340. The charged particle-optical element 300 may be directly attached to the dielectric supporting structure 340.

The charged particle-optical element 300 may be directly attached to the dielectric supporting structure 340 by adhesive. Any appropriate adhesive may be used. For example, the adhesive may be a UV curing adhesive. The adhesive may be provided as a substantially planar adhesive layer 360, for example as shown in figure 10. The planar adhesive layer may be formed over at least part of the facing surfaces of the supporting structure 340 and the charged particle-optical element 300. The planar adhesive layer 360 may be provided as planar zones of adhesive 360, for example as shown in figure 10. The adhesive may comprise spacer balls (as described above).

The dielectric supporting structure 340 may be a mechanically and/or electrically isolating layer. In other words, the dielectric supporting structure 340 may be a layer which separates the charged particle-optical element 300 from the rest of the charged particle-optical stack, i.e. from other plates in a stack of plates 261 and/or other elements in the stack of electron-optical elements of the charged particle-optical device 230. The material of the dielectric supporting structure may be any appropriate material such as, for example, ceramic or glass.

The dielectric supporting structure 340 may be positioned up-beam of the charged particle-optical element 300. In other words, the dielectric supporting structure 340 may be positioned further from the sample or sample location 208 than the charged particle-optical element 300.

The charged particle-optical element 300 may be positioned between the dielectric supporting structure 340 and the detector element 320. The optical element 310 may be positioned between the dielectric supporting structure 340 and the detector element 320. Preferably, the charged-particle optical element 300 and the optical element 310 are positioned between the dielectric supporting structure 340 and the detector element 320, preferably for example directly in-between, for example as shown in figure 10, with no other intermediate elements of the stack. As shown, the optical element 310 and the charged particle-optical element 300 may be stacked (i.e. in the Z direction as shown or along a direction of the charged particle-optical axis when implemented in a charged particle-optical device). The optical element 310 and the charged particle-optical element 300 may be stacked and attached to the dielectric supporting structure 340 as shown in Figure 10.

The dielectric supporting structure 340 may be configured for the passage of one or more charged particle beams. The dielectric supporting structure 340 may define at least one aperture for the passage therethrough of the one or more charged particle beams. The dielectric supporting structure 340 may define a single aperture for the passage therethrough of the one or more charged particle beams. The aperture of the dielectric supporting structure may be associated with, or preferably aligned with, the at least one aperture/arrays of the charged particle-optical element 300. Thus, the at least one or more charged particle beams may pass through the aperture defined in the dielectric supporting structure 340 to the at least one aperture of the charged particle-optical element 300.

The assembly 50 may comprise multiple dielectric supporting structures. Thus, the dielectric supporting structure 340 may be a first dielectric supporting structure 340 and the assembly 50 may comprise a second dielectric supporting structure 350. The second dielectric supporting structure 350 may be positioned between the first dielectric supporting structure 340 and the detector element 320, preferably for example directly in-between, for example, as shown in figure 10. In this embodiment, the second dielectric supporting structure 350, the optical element 310, and the charged particle-optical element 300 may be positioned between the first dielectric supporting structure 340 and the detector element 320. In other words, the dielectric supporting structure 350, the optical element 310 and the charged particle-optical element 300 may be directly in-between the first dielectric supporting structure 340 and the detector element 320. It is noted that additional components/elements may also be provided between the first dielectric supporting structure 340 and the detector 320 (for example, the wave guide array described further below). As already described, the optical element 310 and the charged particle-optical element 300 may be stacked. The stack of the optical element 310 and the charged particle-optical element 300 may be adjacent to the second dielectric supporting structure 350. The combined thickness of the stacked optical element 310 and the charged particle-optical element 300 (in the Z direction or along a direction of the charged particle-optical axis when implemented in a charged particle-optical device) may be less than the thickness of the second dielectric supporting structure 350. Thus, elements which may be thinner than the second dielectric supporting structure 350, such as the optical element 310 and the charged particle-optical element 300 may be stacked in the Z direction and positioned adjacent to the second dielectric supporting structure 350 which is thicker in the Z direction, so as to take up a smaller distance in the Z direction as possible.

The second dielectric supporting structure 350 may be configured to support the detector element 320. The second dielectric supporting structure 350 may be configured to attach to the detector element 320. The second dielectric supporting structure 350 may be configured to directly attach to the detector element 320. The second dielectric supporting structure 350 may be directly attached to the detector element 320 by adhesive, for example by a planar adhesive layer 366 as shown in figure 10. The adhesive layer between the second dielectric supporting structure 350 and the detector element 320 may be as described in any of the above references to the adhesive. Although it is noted that there may be a greater area of attachment (for example, a larger planar layer of adhesive 366 when compared to the adhesive layers (for example, 360, 361) in the remainder of the assembly) between the detector element 320 and the second dielectric supporting structure 350 as the detector element 320 may be larger in the X-Y plane than the charged particle-optical element 300 and/or the optical element 310 described above.

The second dielectric supporting structure 350 may be of any appropriate shape to support the detector element 320. The second dielectric supporting structure 340 may be positioned adjacent to at least one side surface of the optical element 310 and/or at least one side surface of the charged particle-optical element 300. For example the second dielectric supporting structure may be substantially U-shaped, for example as shown in figure 11. In this case, the second dielectric supporting structure 350 is adjacent to three sides of the optical element 310 and/or the charged particle-optical element 300.

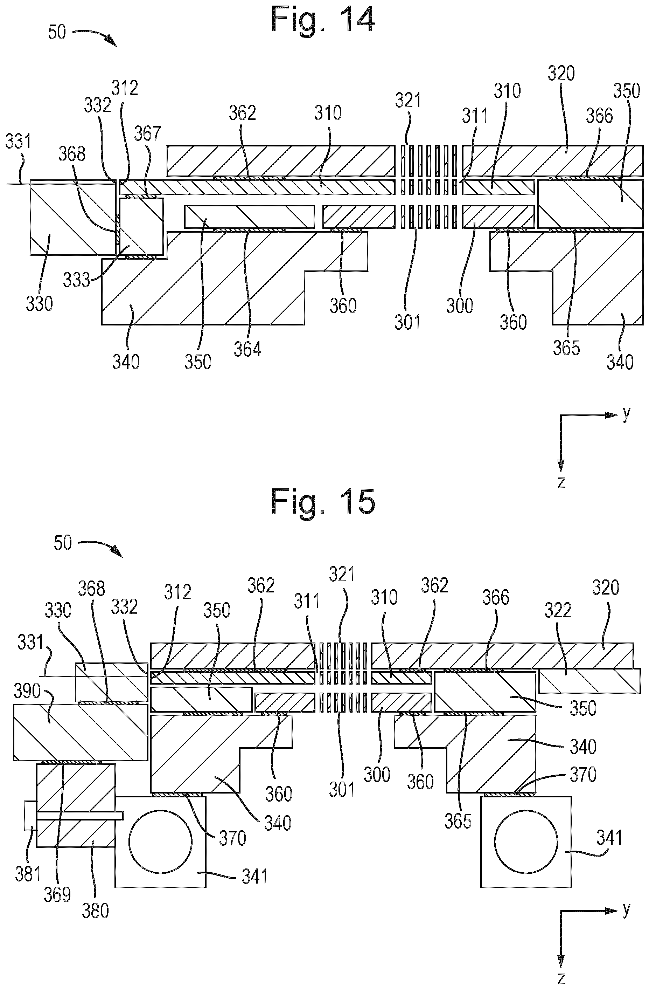

The second dielectric supporting structure 350 may be provided in alternative shapes. For example, the second dielectric supporting structure 350 may be rectangular and defining an aperture therethrough. The aperture may be a central aperture. The aperture may be provided so that the charged particle-optical element 300 and/or the optical element 310 may be positioned within the aperture. In this case, one of the sides of the second dielectric supporting structures may be recessed, for example, so as to provide space for other components or elements to be positioned adjacent or on the recessed side. Such a variation is described in one of the further embodiments below in which part of the optical element 310 is positioned between the second dielectric supporting structure 350 and the detector element 320, for example,. directly in-between as depicted in figure 14).

Preferably, the aperture in the first dielectric structure 340 is smaller than the aperture in the second dielectric structure 350. Although any shape may be used for the aperture in each of the first dielectric structure 340 and the second dielectric structure 350 (which may be substantially similar in shape, or different in shape from each other), preferably, the aperture in the first dielectric structure 340 is substantially circular and the aperture in the second dielectric structure 350 is substantially rectangular.

The assembly may further comprise a waveguide array which is optically coupled to the optical element 310 for providing optical radiation from an external source to the optical element 310. The external source may be a coherent source, for example a laser source.

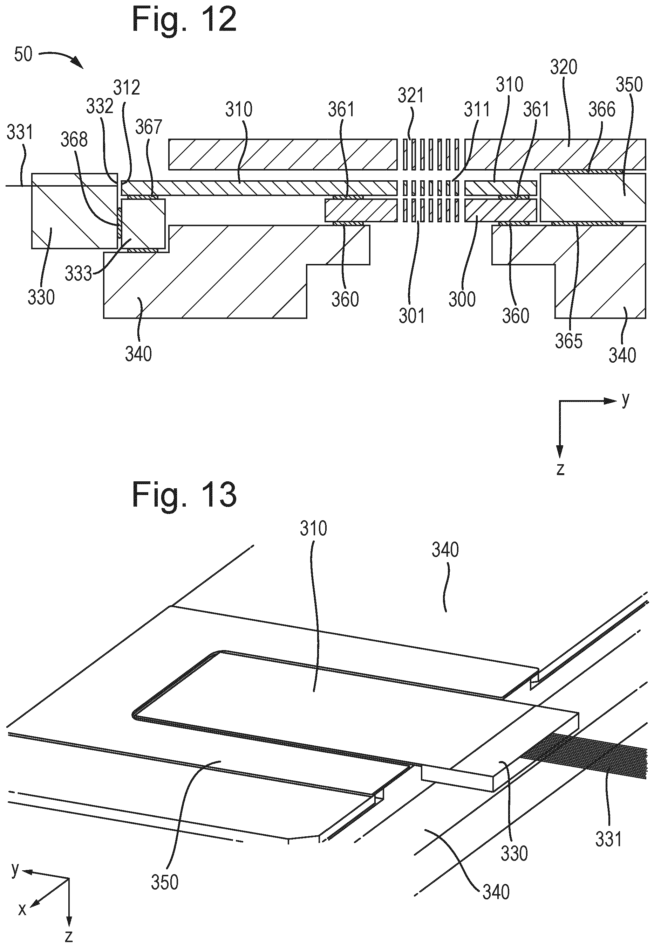

Thus, the assembly 50 may further comprise the waveguide array 330. The waveguide array 330 may be positioned between the first dielectric supporting structure 340 and the detector element 320. The waveguide array 330 may be positioned directly in-between the first dielectric supporting structure 340 and the detector element 320 (for example, as shown in figure 10). The waveguide array 330 may be positioned adjacent to a stack comprising the charged particle-optical element 300 and the optical element 310. The waveguide array 330, the charged particle-optical element 300, the optical element 310 and the second dielectric supporting structure 350 may be positioned between the first dielectric supporting structure 340 and the detector element 320. The waveguide array 330 may preferably be configured so as to avoid adding additional thickness to the assembly 50 in the Z direction. For example, the waveguide array may be between approximately 0.3 mm to 2.0 mm. For example, the waveguide array may be relatively thin when positioned directly in-between the first dielectric supporting structure 340 and the detector element 320 (for example, as in figure 10) compared to other embodiments (for example, Fig. 12, 14) where the waveguide array is not positioned directly in-between the first dielectric supporting structure 340 and the detector element 320. That is, the waveguide array 330 as shown in Fig. 10 may be thinner than the waveguide array 330 in other embodiments, where it may be positioned in such a way that it extends substantially outside a region defined by at least the first dielectric supporting structure 340.

The waveguide array 330 may comprise optical fibers 331. The optical fibers 331 may be provided in an array. An example of the array of optical fibers is more clearly shown in figure 11. The optical fibers 331 in particular may be used for providing optical radiation from the external source to the optical element 310. The waveguide array 330 may comprise a channel (e.g. a V-shaped groove) for holding each optical fiber. The optical fibers are optically coupled to the optical element 310 such that the optical fibers enable the transmission of optical radiation from the external optical source (coherent source) into waveguides in the optical element 310 and that the optical element 310 is further configured to project the optical radiation towards the sample 208. Thus, by "optical coupling" we mean aligning one or more optical fibers in the optical fiber array to optical components (e.g. waveguides) in the optical element 310 such that the optical components receive optical radiation from the aligned optical fibers.

The waveguide array 330 may be directly attached to and/or in contact with the first dielectric supporting structure 340. The waveguide array 330, the charged particle-optical element 300 and the second dielectric supporting structure 350 may be directly attached to, and/or in contact with, the first dielectric supporting structure 340, for example as shown in figure 10. The waveguide array 330, charged particle-optical element 300 and/or the second dielectric supporting structure 350 may be directly attached to the first dielectric supporting structure 340 by means of adhesive. The adhesive may be as described in any of the above embodiments. For example, a planar adhesive layer may be provided between each of these elements and the first dielectric supporting structure. For example, as shown in figure 10, adhesive layer 363 is shown between the waveguide array 330 and the first dielectric supporting structure 340, adhesive layer 360 is shown between the charged particle-optical element 300 and the first dielectric supporting structure 340, and the adhesive layer 365 is shown between the second dielectric supporting structure 350 in the first dielectric supporting structure 340.

In the present embodiment, for example as shown in figures 10 and 11, the first dielectric supporting structure 340 can be used for supporting the other elements and thus, may be relevant for alignment of such elements. For example, at least the detector element 320, the optical element 310 and the charged particle-optical element 300 may be associated with each other and aligned with respect to each other in that they are assembled to enable the passage of the one or more charged particle beams towards the sample.

The waveguide array 330 may be spaced apart from the optical element 310. In other words, there may be a gap between the waveguide array 330 and the optical element 310 (i.e. a gap in the Y direction shown in figures 10-14). Preferably, the gap is several micrometers. Preferably the gap is between 5-100 micrometers. During use, for example in the charged particle-optical apparatus 140, a non-dispersive medium may be present between the waveguide array 330 and the optical element 310 for propagation of optical radiation from the waveguide array 330 into the optical element 310.

More specifically, the waveguide array 330 may be spaced apart from the optical element 310 with respect to optically coupled facing surfaces. The optical element may comprise a coupling surface 312 and the waveguide array 330 may comprise a coupling surface 332 and the waveguide array may be optically coupled to the optical element 310 via the respective coupling surfaces. The optical element 310 and the waveguide array 330 may be connected, directly or indirectly, to define a gap between the corresponding optically coupled surfaces (i.e. between the facing surfaces of the waveguide array 330 and the optical element 310). Thus, the assembly 50 is configured such that the waveguide array 330 and the optical element 310 are spaced apart from each other while still allowing for optical radiation to pass from the waveguide array into the optical element 310 via the optically coupled surfaces. The optically coupled surfaces of the waveguide array 330 and the optical element 310 are facing surfaces. In figure 10, it is noted that the waveguide array 330 and the optical element 310 are indirectly connected via other components, in this instance, the first dielectric supporting structure 340 and the charged particle optical element 300. Thus, there is a physical separation between the waveguide array which comprises the fibers for connecting to the external source and the optical element 310. Preferably, there is no specific element positioned between the two components, for example the gap does not include a layer of material such as an epoxy layer or any other dispersive medium between the waveguide array 330 and the optical element 310.

Although the above embodiment provides one way of connecting the relevant elements, other structures/forms of attachment are available.

For example, the waveguide array 330 may be positioned outside of a region defined by the first dielectric supporting structure 340. In a further example, the waveguide array 330 may be positioned outside of a region defined between the first dielectric supporting structure 340 and the detector element 320, for example as shown in figures 12 and 13.

In this embodiment, the waveguide array 330 is attached to the optical element 310. The waveguide array 330 may be indirectly attached to the optical element 310 via an attachment structure. For example, the assembly 50 may comprise an attachment structure such as a stiffening element 333 attached to the optical element 310 and attached to the waveguide array 330, so as to attach the waveguide array 330 to the optical element 310. The attachment structure or stiffening element 333 may be directly attached to the optical element 310 and directly attached to the waveguide array 330. The waveguide array 330 may be attached to the optical element 310 using adhesive. The adhesive may be as described in any of the above embodiments/variations. The stiffening element 333 may be part of or integrated with the waveguide array 330. In this embodiment, the waveguide array 330 is more closely linked to the optical element 310. Although it is shown in figure 12 that the stiffening element 333 is attached to the first dielectric supporting structure 340, this is not a necessity.

In the present embodiment, at least part of the waveguide array 330 may not be supported by the first dielectric supporting structure 340 but is attached to the optical element 310 which supports the waveguide array 330 whilst maintaining the gap between the optically coupling surfaces of the waveguide array 330 and the optical element 310.

This embodiment may be beneficial in that it allows for a slightly reduced thickness in the stacking direction due to the waveguide array no longer being positioned between the detector element 3320 and the first dielectric supporting structure 340.

An alternative embodiment is shown in figure 14 in which the optical element 310 is attached to the detector element 320 rather than the charged particle-optical element 300 (as in the above embodiments). As described above, the waveguide array 330 may be positioned outside of a region defined by the first dielectric supporting structure 340. As can be seen in figure 14, the waveguide array 330 may be positioned outside of the region defined between the first dielectric supporting structure 340 and the detector element 320 as described in the preceding embodiment.

In the present embodiment, the optical element 310 may not be directly in contact with the charged particle-optical element 300. Instead, the optical element 310 may be directly attached to the detector element 320 by any suitable attachment means. In Fig. 14, an adhesive layer 362 is provided between the optical element 310 and the detector element 320. The adhesive may be as described in any of the above embodiments. Although not a necessity, a portion of the second dielectric supporting structure 350 may be positioned between the optical element 310 and the first dielectric supporting structure 340. This is shown in figure 14. The portion of the second dielectric supporting structure 340 positioned between the optical element 310 and the first dielectric supporting structure 340 may be a recessed side of the second dielectric supporting structure 350, for example when the second dielectric supporting structure 350 is rectangular with an aperture in which at least the charged particle-optical element 300 is positioned (as described above).

Although not shown in figure 14, the portion of the second dielectric supporting structure 350 positioned between the first dielectric supporting structure 340 and the optical element 310 may be in contact with the optical element 310 and optionally may be attached to the optical element 310, for example using adhesive as described above. Although not a necessity, this may be useful in providing extra structural rigidity.

The portion of the second dielectric supporting structure 350 may be directly attached to the first dielectric supporting structure 340.

In the above embodiments it is described that in at least one variation, a gap/spacing can be provided between the waveguide array 330 and the optical element 310. In an embodiment, an optical component may be provided comprising the optical element configured to project optical radiation towards the sample, wherein the optical element comprises a coupling surface 312 and a waveguide array 330 comprising a coupling surface 332, wherein the waveguide array 330 is optically coupled to the optical element 310 via the coupling surfaces 312, 332. As shown in the above embodiments, the optical element 310 and the waveguide array 330 may be connected directly or indirectly to define a gap between the coupling surfaces. The various components may be provided as described in any of the above variations and embodiments, for example the waveguide array may comprise the optical fibers which may be provided in an array. For the avoidance of doubt, the gap between the coupling surface may correspond to the spacing between the optical element and the waveguide array 330. Within the gap, a non-dispersive medium may be present, for example, during use, that is. in a vacuum. However, it is possible that other mediums are included in the gap, for example adhesive or alternative attachment means.

An advantage of the variations shown in figure 12-14 is that the sub-assembly of the optical element 310 and the waveguide array 330 (which may be referred to as an optical component), may be more easily manufactured as a sub-assembly to be included in the assembly 50 (or more broadly in a charged particle optical device 230). However, the sub-assembly may require very delicate handling due to the optical fibers and due to parts of the sub-assembly preferably being very thin to fit within the space constraints within an assembly and/or charged particle optical device 230.

Advantageously, known technology can be used for handling such components and/or assemblies to allow for delicate handling and accurate placement in line with the description of the device above. For example, a die placer (which may otherwise be referred to as assembly equipment, a die bonder and/or equipment for die bonding, e.g. sub-micron die bonding) can be used for carefully controlling position of components during assembly and can be used for steps involved in providing planar adhesive layers as described above. Furthermore, alignment of components can be carried out using known techniques, such as relying on markers (which may otherwise be referred to as fiducials) on corresponding components to determine alignment during placement of a given component (i.e. active alignment, e.g. using a camera). For example, the waveguide array 330 and the optical element 310 may comprise corresponding markers which can be used for active alignment during placement of one of the elements relative to the other.

In further detail, stacking the elements as in the above assembly (e.g. using the die placer/assembly equipment) may improve, and preferably optimize, alignment of the waveguide array 330 with respect to the optical element 310, preferably to micrometer level. By providing the above assembly, alignment of the waveguide array 330 with respect to the optical element 310 may only be required in less than six degrees of movement. For example, alignment may only be need to be done in x, y and Rz. For example, the assembly equipment may be used for active alignment of the waveguide array with respect to the optical element 310 in the X and Y directions which may, for example, be optimized to a micrometer level on the basis of measured optical power through pilot channels and after which the optimized alignment is then permanently fixated using UV curing adhesive. The other degrees of freedom may be controlled either by part tolerances or by utilizing the metrology capabilities of the assembly equipment. To aid accurate initial placement of the waveguide array, the top surface of the waveguide array may comprise at least one marker (e.g. fiducials) to allow for optical position measurement.

In any of the above embodiments, the assembly 50 may comprise at least one cooling element 341 for cooling surrounding elements. The at least one cooling element may defines a channel for the passage therethrough of a fluid. The at least one cooling element may define a channel for the passage therethrough of a liquid. The at least one cooling element may define a channel for the passage therethrough of water. The cooling element may comprise titanium. The cooling element may be formed of titanium. The at least one cooling element 341 may be part of, or attached directly to, the first dielectric supporting structure 340. For example as shown in figure 15, the at least one cooling element 341 may be attached to the first dielectric supporting structure 340 via an adhesive 370.

In any of the above embodiments, the assembly 50 may comprise a connector 380 for attaching the waveguide array 330 to another part of the assembly 50. The connector comprises a removable attachment mechanism. The connector comprises a bolted mechanical part. In particular, the bolted mechanical part may be connected to the first dielectric supporting structure 340, preferably directly attached to the first dielectric supporting structure. In particular, the bolted mechanical part may be connected to the cooling element 341, for example as shown in figure 15. In particular, the bolted mechanical part may be directly attached to the cooling element 341, for example as shown in figure 15. The connector 380 provides a mechanical platform.

The assembly may further comprise a platform 390 configured to support the waveguide array. The platform may comprise glass. The platform 390 may comprise a first surface for direct attachment to the waveguide array 330. The waveguide array may be attached to the said first surface by adhesive 368. The adhesive may be a planar adhesive layer. The adhesive may comprises spacer balls (as described above). The platform 390 comprises a second surface for direct attachment to the connector 380 for attaching the waveguide array to another part of the assembly. The waveguide array may be attached to the second surface by adhesive. The adhesive may be a planar adhesive layer. The adhesive may comprises spacer balls (as described above).

In an embodiment, on the mechanical platform 380, the platform 390, preferably, a glass platform, can be bonded, where the platform has high tolerances compared to the mechanical platform 380. For example, the platform 390 can be bonded to the connector 380 via attachment means 369 which may comprise adhesive. The advantage of the platform 390 is to create an accurate mounting platform for the fiber array.

The embodiment, for example, as shown in figure 15, is beneficial in that the optical element 310 can be attached to the detector element 320. This may be preferred to attaching the optical element 310 to the charged particle-optical element 300 because this makes it easier to get the optical spots in focus in the correct z-plane due to the tolerance of the handle layer of the optical element 310 - when attaching, for example, gluing, optical element 310 to detector element it becomes relatively unimportant how thick the optical element is exactly. Additionally, attachment to the detector element can improve the thermal path from optical element to cooling. If the heat flows to the charged particle-optical element, the charged particle-optical element may warm up potentially leading to beam stability issues. For this reason, it is preferred if the optical element 310 is thermally coupled to the detector element. The embodiment in Fig. 15 also shows an optional component 322 as part of the assembly 50 where 322 enables electrical connections to the detector 320.

Additionally, the embodiment shown in figure 15 allows for easier repair of the fibers . In providing the embodiment in figure 15, a method may comprise attaching the optical element 310 to the detector element 320, preferably directly to the detector element 320, to form a sub-assembly; attaching the charged particle-optical element 300 to the optical assembly 50 and stacking the sub-assembly and charged particle-optical element 300 such that the optical element is positioned between the detector element 320 and the charged particle-optical element 300.

In an embodiment, a method of providing an optical assembly, or even an optical component, as in any of the above embodiments is provided.

For embodiments in which the optical element 310 is directly attached to the charged particle optical element 300, the method may comprise attaching directly the optical element 310 to the charged particle optical element 300 and attaching the detector element 320 to the assembly 50 wherein the optical element 310 is positioned between the detector element 320 and the charged particle optical element 300. The method may comprise attaching the charged particle optical element 300 to the first dielectric supporting structure 340 prior to attachment of the optical element 310. Although, this is not a necessity and the optical element 310 could be attached to the charged particle optical element 300 and then both components could be attached to the first dielectric supporting structure 340. The method may comprise attaching the waveguide array 330 to the optical assembly 350. The waveguide array 330 may be attached prior to attachment of the detector element 320. This may be beneficial in what usually attaching the waveguide array 330 to the assembly 50 before the detector element 320 is attached on top of the waveguide array 330. However, this is not a necessity as if the detector element 320 is already attached to the rest of the assembly 50, the waveguide array 330 could be installed from a side of the assembly 50, for example by moving the waveguide array 330 into position along the X direction as shown in figure 10. The method may comprise attaching the second dielectric supporting structure 350 on the first dielectric supporting structure 340. The second dielectric supporting structure 350 may be attached directly to the first dielectric supporting structure 340. The second dielectric supporting structure 350 may be attached prior to attachment of the detector element 320 so as to provide a support for the detector element 320 in the assembly.

More specifically, the method may be used for providing the optical assembly as shown in figures 10 and 11 for example. In particular, the method may comprise:
- Stacking elements up to the optical element, including the charged particle optical element 300 on the first dielectric support structure 340, and the optical element 310 on the charged particle optical element 300 (before the waveguide array is attached/stacked). Preferably, the detector element 320 is stacked so as to be substantially flat (i.e. parallel to the XY plane shown in figures). As the second dielectric supporting structure 350 and the waveguide array 330 may be of similar thickness, either the waveguide array may be selected to be slightly thinner than the detector or spacer balls used in the adhesive layer for the detector element are large enough to close the tolerance train. Avoiding contact between the detector element and the waveguide array is beneficial in that the detector element may be flat and resting on the second dielectric support structure, preferably only, and/or this can allow freedom to insert the waveguide element after the detector element is attached.
- The waveguide array is preferably aligned with the die placer (for example, in x, y, Rz) with respect to the optical element 310. The waveguide array can be directly attached to the first dielectric supporting structure 340 using adhesive.

The above specific method is beneficial in that more difficult assembly steps associated with handling of the waveguide array comprising optical fibers can be carried out in a single step. In this method, the risk of breaking the optical element 310 and/or the waveguide array 330 is likely to be reduced due to the ability to stack the elements without having to handle more delicate subassemblies of components.

An alternative method of providing the optical assembly may be provided in which the waveguide array is attached to the optical element 310 and then the optical element 310 is attached to the charged particle optical element 300. In this way, the waveguide array 330 is attached to the optical element 310 and then they sub-assembly can be attached as a unit to other components of the assembly 50. The waveguide array 330 when attached to the optical element 300 may form the optical component described above. The invention may further comprise attaching the detector element to the assembly, wherein the optical element 310 is positioned between the detector element 320 and the charged particle optical element 300. This method may comprise attaching the charged particle optical element 300 to the first dielectric supporting structure 340 prior to attachment of the optical element 310. The method may further comprise attaching the second dielectric supporting structure 350 on the first dielectric supporting structure 340. As described above, the second dielectric supporting structure 350 can be directly attached to the first dielectric supporting structure 340. The second supporting structure 350 may be attached prior to attachment of the detector element 320 so as to provide a supporting surface on which the detector element 320 can be attached to the rest of the assembly.

More specifically, the alternative method may be used for providing the optical assembly as shown in figures 12 and 13 for example. In particular, the method may comprise:
- Loading the waveguide array 330 comprising the array of optical fibers 331, wherein the waveguide array is loaded in a die placer. Optionally, the array of optical fibers are connected to a readout device.
- Stacking the optical element 310 to the waveguide array to form a sub-assembly/optical component. The adhesive layer can be located in the overlap area between the between the waveguide array and the optical element. As described above, a gap can be maintained (even if not on a visible scale) between the optically coupling surfaces of the waveguide array and the optical element, wherein said gap is not filled with glue.
- The sub-assembly is stacked to other parts of the assembly 50. Cooling and potting may be done before or after this step. If potting is already done, the second dielectric supporting structure is added at an earlier stage.

Potential advantages of the specific alternative method described above include that: the waveguide array may be thicker as it is not provided between the first dielectric support structure and the detector element; the glue layer is planar in XY; and assembly of the optical element can be carried out using known technologies.

The optical assembly 50 and/or optical component is generally described for a multi-beam system, i.e. in relation to multiple charged particle beams. However, the optical assembly 50 and/or optical component may also be used for other e-beam designs including other multi-beam designs and single-beam designs. It may also be used in lithography applications, for example in e-beam lithography systems.

As will be understood, the optical assembly and/or optical component as described in any of the above variations or embodiments may be provided as part of a charged particle-optical device 230, wherein the charged particle-optical device is configured to project one or more charged particle beams towards the sample. Preferably, a major surface of the detector element is in the downbeam surface of the charged particle optical device, and the major surface of the detector element 320 is configured to face the sample 208.

In an embodiment, as assessment apparatus is provided for inspecting the sample 208, wherein the assessment apparatus comprises the charged particle-optical device described above.

In an embodiment the electron-optical apparatus 140 comprises a secondary electron-optical device comprising the detector array 240. In such an embodiment a beam separator typically is arranged to deflect the path of the signal electrons towards the secondary electron-optical device. The secondary electron-optical device subsequently directs the signal electrons towards the detector array 240 and focuses the signal electrons (e.g. secondary electrons) onto the detector array 240.

In an embodiment any electron-optical element or group of electron-optical elements may be replaceable or field replaceable within the electron-optical apparatus 140. Field replaceability means that the electron-optical element or group of electron-optical elements may be replaced without substantially disassembling the electron-optical apparatus 140. In an embodiment the electron-optical apparatus 140 comprises at least one module. Each module comprises a group of adjacent electron-optical elements. The electron-optical elements of a module may be secured to each other, for example as a stack.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

In an embodiment, the assessment apparatus 100 comprises a plurality of position sensors. The position sensors may be or comprise level sensors. The position sensors may be capacitive sensors and/or differential sensors. The position sensors may be positioned on a surface of an electron-optical element (e.g. a detector array) of the electron-optical apparatus 140. The surface may be configured to face the sample 208. The position sensors may be positioned around and away from the beam paths. In an embodiment, the position sensors are connected to the ground potential. In an embodiment, electronics associated with the position sensors are connected to the ground potential. In an embodiment the position sensors are configured to output signals to the controller 150. The position sensors may be operated to determine the position of the sample surface and a facing surface of the electron-optical device relative to each other.

An electric power source may be provided to supply power to the assessment apparatus 100 and/or electron-optical apparatus 140. For example, such a power supply may apply respective potentials to electrodes of lenses of the electron-optical device 230.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208.

The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

The electron-optical device 230 may be provided as a column. The column may comprise an objective lens assembly. Optionally the electron-optical device 230 comprise the source 201. Alternatively, the source 201 may be separate from the electron-optical device 230. The electron-optical apparatus 140 may be locatable on an apparatus footprint in a chip fabrication facility. Environmental conditioning systems and processors such as process/data racks may be remote from the part of the electron-optical apparatus 140 present on the apparatus footprint. Such environmental conditioning systems may comprise part of a thermal conditioning system and part of a vacuum system.

In an embodiment the electron-optical apparatus 140 comprises one or more liner tubes (not shown). The liner tube is for shielding the beam paths from external fields, for example when the source 201 is at a higher potential than the sample 208 relative to a ground potential. The liner tube may extend between different components of the electron-optical apparatus 140. For example, a liner tube may extend between the source 201 and an upbeam surface of a stack of plates 261 which forms an objective lens array. The liner tube, if spaced away from the objective lens array and at a different potential from a facing surface of the objective lens array may provide a lensing function.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

Embodiments of the disclosure are defined in the following numbered clauses:
1. An optical assembly for a charged particle-optical device configured to project one or more charged particle beams towards a sample, wherein the optical assembly comprises:
   a charged particle-optical element configured for passage of the one or more charged particle beams;
   a detector element for detecting charged particles emitted from the sample in relation to the one or more charged particle beams;
   an optical element configured to project optical radiation towards the sample,
   wherein the optical element is configured to be positioned between the charged particle-optical element and the detector element and is further configured to be directly attached by adhesive to the charged particle-optical element or the detector element.
2. The optical assembly of clause 1, wherein the adhesive is a planar adhesive layer.
3. The optical assembly of either of clauses 1 or 2, wherein the adhesive comprises spacer balls.
4. The optical assembly of any one of the preceding clauses, wherein the optical element is adjacent to the charged particle-optical element and the detector element.
5. The optical assembly of any one of the preceding clauses, wherein the optical element defines at least one aperture for the passage therethrough of the one or more charged particle beams.
6. The optical assembly of clause 5, wherein the charged particle-optical element defines at least one aperture for the passage therethrough of the one or more charged particle beams.
7. The optical assembly of clause 6, wherein the at least one aperture of the charged particle-optical element is associated with the at least one aperture of the optical element for passage of the one or more charged particle beams.
8. The optical assembly of clause 7, wherein the at least one aperture of the charged-particle optical element is aligned with the at least one aperture of the optical element.
9. The optical assembly of any one of clauses 5 to 8, wherein the detector element comprises at least one aperture for the passage therethrough of the one or more charged particle beams.
10. The optical assembly of clause 9, wherein the at least one aperture of the detector element is associated with the at least one aperture of the optical element for passage of the one or more charged particle beams.
11. The optical assembly of clause 10, wherein the at least one aperture of the detector element is aligned with the at least one aperture of the optical element.
12. The optical assembly of any one of the preceding clauses, further comprising a dielectric supporting structure configured to support the said charged particle-optical element.
13. The optical assembly of clause 12, wherein the charged particle-optical element is attached to the dielectric supporting structure.
14. The optical assembly of either of clauses 12 or 13, wherein the dielectric supporting structure is a spacer layer.
15. The optical assembly of any one of clauses 12 to 14, wherein the charged particle-optical element is positioned between the dielectric supporting structure and the detector element.
16. The optical assembly of any one of clauses 12 to 15, wherein the optical element is positioned between the dielectric supporting structure and the detector element.
17. The optical assembly of any one of clauses 12 to 16, wherein the dielectric supporting structure is configured for the passage of the one or more charged particle beams.
18. The optical assembly of clause 17, wherein the dielectric supporting structure defines at least one aperture for the passage therethrough of the one or more charged particle beams.
19. The optical assembly of any one of clauses 12 to 18, wherein the dielectric supporting structure is a first dielectric supporting structure, and the optical assembly further comprises a second dielectric supporting structure positioned between the first dielectric supporting structure and the detector element.
20. The optical assembly of clause 19, wherein the second dielectric supporting structure, the optical element and the charged particle-optical element are positioned between the first dielectric supporting structure and the detector element.
21. The optical assembly of either of clauses 19 or 20, wherein the optical element and the charged particle-optical element are stacked and are positioned adjacent to the second dielectric supporting structure.
22. The optical assembly of any one of clauses 19 to 21, wherein the second dielectric supporting structure is substantially (i) U-shaped, or (ii) rectangular and defining an aperture therethrough, wherein one of the sides is recessed.
23. The optical assembly of any one of clauses 19 to 22, wherein the second dielectric supporting structure is positioned adjacent to at least one side surface of the optical element and/or at least one side surface of the charged particle-optical element.
24. The optical assembly of any one of clauses 19 to 23, wherein the second dielectric supporting structure is directly attached, or in contact with, the detector element.
25. The optical assembly of any one of clauses 19 to 24, wherein a portion of the second dielectric supporting structure is positioned between the optical element and the first dielectric supporting structure.
26. The optical assembly of any one of the preceding clauses, further comprising at least one cooling element for cooling surrounding elements.
27. The optical assembly of any one of clauses 12 to 25, further comprising at least one cooling element for cooling surrounding elements wherein the cooling element is part of, or attached directly to, the first dielectric supporting structure.
28. The optical assembly of either one of clauses 26 or 27, wherein the at least one cooling element defines a channel for the passage therethrough of a fluid.
29. The optical assembly of any one of clauses 26 to 28, wherein the cooling element comprises titanium.
30. The optical assembly of any one of the preceding clauses, further comprising a waveguide array which is optically coupled to the optical element for providing optical radiation from an external source to the optical element.
31. The optical assembly of any one of clauses 12 to 29, further comprising a waveguide array which is optically coupled to the optical element.
32. The optical assembly of clause 31, wherein the waveguide array is positioned between the first dielectric supporting structure and the detector element.
33. The optical assembly of either of clauses 31 or 32, wherein the waveguide array, the charged-particle optical element and the second dielectric supporting structure are in directly attached to, and/or in contact with, the first dielectric supporting structure.
34. The optical assembly of clause 31, wherein the waveguide array is positioned outside of a region defined between the first dielectric supporting structure and the detector element.
35. The optical assembly of clause 34, wherein the waveguide array is attached to the optical element.
36. The optical assembly of clause 35, wherein the waveguide array is indirectly attached to the optical element.
37. The optical assembly of any one of clauses 31-36, further comprising an attachment structure, preferably, a stiffening element attached to the optical element and attached to the waveguide array, so as to attach the waveguide array to the optical element.
38. The optical assembly of any one of clauses 31-36, further comprising a connector for attaching the waveguide array to another part of the assembly.
39. The optical assembly of clause 38, wherein the connector comprises a removable attachment mechanism.
40. The optical assembly of clause 39, wherein the connector comprises a bolted mechanical part.
41. The optical assembly of any one of clauses 38 to 40, wherein the assembly comprises at least one cooling element for cooling surrounding elements the connector is directly attached to the cooling element.
42. The optical assembly of any one of clauses 38 to 41, wherein the assembly comprises a further dielectric supporting structure and the connector is attached, preferably directly attached, to the further dielectric supporting structure.
43. The optical assembly of any one of clauses 31 to 42, further comprising a platform configured to support the waveguide array.
44. The optical assembly of clause 43, wherein the platform comprises glass.
45. The optical assembly of clause 44, wherein the platform comprises a first surface for direct attachment to the waveguide array.
46. The optical assembly of clause 45, wherein the waveguide array is attached to the first surface by adhesive.
47. The optical assembly of clause 46, wherein the adhesive is a planar adhesive layer.
48. The optical assembly of clause 46 or 47, wherein the adhesive comprises spacer balls.
49. The optical assembly of any one of clauses 43 to 48, wherein the platform comprises a second surface for direct attachment to a connector for attaching the waveguide array to another part of the assembly.
50. The optical assembly of clause 49, wherein the waveguide array is attached to the second surface by adhesive.
51. The optical assembly of clause 50, wherein the adhesive is a planar adhesive layer.
52. The optical assembly of clause 50 or 51, wherein the adhesive comprises spacer balls.
53. The optical assembly of any one of clauses 35 to 52, wherein the waveguide array is attached to the optical element using adhesive.
54. The optical assembly of any one of clauses 31 to 53, wherein the waveguide array is directly attached to the first dielectric supporting structure.
55. The optical assembly of any one of clauses 31 to 54, wherein the waveguide array comprises optical fibres.
56. The optical assembly of clause 55, wherein the optical fibres are provided in an array.
57. The optical assembly according to any one of clauses 31 to 56, wherein waveguide array is spaced apart from the optical element and wherein a non-dispersive medium is disposed between the waveguide array and the optical element for propagation of optical radiation from the waveguide array into the optical element.
58. The optical assembly of either one of clauses 31 to 57, wherein the optical element comprises a coupling surface and the waveguide array comprising a coupling surface, wherein the waveguide array is optically coupled to the optical element via the coupling surfaces, and wherein optical element and the waveguide array are connected, directly or indirectly, to define a gap between the coupling surfaces.
59. The optical assembly of any one of the preceding clauses, wherein the detector element comprises at least one electrical connection for electrically coupling the detector to other elements of the assembly.
60. An optical component for a charged particle-optical device configured to project one or more charged particle beams towards a sample, wherein the optical component comprises:
   a optical element configured to project optical radiation towards the sample, wherein the optical element comprises a coupling surface; and
   a waveguide array comprising a coupling surface, wherein the waveguide array is optically coupled to the optical element via the coupling surfaces,
   and wherein optical element and the waveguide array are connected, directly or indirectly, to define a gap between the coupling surfaces.
61. The optical component of clause 60, wherein the waveguide array comprises optical fibres.
62. The optical component of clause 61, wherein the optical fibres are provided in an array.
63. The optical component of any one of clauses 60 to 62, wherein a non-dispersive medium is disposed between the waveguide array and the optical element for propagation of optical radiation from the waveguide array into the optical element
64. A method of providing an optical assembly of any one of clauses 1 to 59, wherein the method comprises:
   - attaching directly the optical element to the charged particle-optical element; and
   - attaching the detector element to the optical assembly, wherein the optical element is positioned between the detector element and the charged particle-optical element.
65. The method of clause 64, further comprising attaching the charged particle-optical element to a first dielectric supporting structure prior to attachment of the optical element.
66. The method of either of clauses 64 or 65, further comprising attaching a waveguide array to the optical assembly.
67. The method of clause 66, wherein the waveguide array is attached prior to attachment of the detector element.
68. The method of any one of clauses 64 to 67, further comprising attaching a second dielectric supporting structure on the first dielectric supporting structure.
69. The method of clause 68, wherein the second dielectric supporting structure is attached directly to the first dielectric supporting structure.
70. The method of either of clauses 68 or 69, wherein the second dielectric supporting structure is attached prior to attachment of the detector element.
71. A method of providing an optical assembly of any one of clauses 1 to 59, wherein the method comprising:
   - attaching the waveguide array to the optical element;
   - then attaching the optical element to the charged particle-optical element; and
   - attaching the detector element to the assembly, wherein the optical element is positioned between the detector element and the charged particle-optical element.
72. The method of clause 71, further comprising attaching the charged particle-optical element to a first dielectric supporting structure prior to attachment of the optical element.
73. The method of either of clauses 71 or 72, further comprising attaching a second dielectric supporting structure on the first dielectric supporting structure.
74. The method of clause 73, wherein the second dielectric supporting structure is attached directly to the first dielectric supporting structure.
75. The method of either of clauses 73 or 74, wherein the second dielectric supporting structure is attached prior to attachment of the detector element.
76. A charged particle optical device configured to project one or more charged particle beams towards a sample, the charged particle-optical device comprising an optical assembly according to any one of clauses 1 to 59 and/or an optical component according to any one of clauses 60 to 63.
77. The charged particle-optical device of clause 76, wherein a major surface of the detector element is a most downbeam surface of the charged particle-optical device, and wherein the major surface is configured to face the sample.
78. An assessment apparatus for inspecting the sample, comprising the charged particle-optical device of either of clauses 76 or 77.
79. A method of providing an optical assembly of any one of claims 1-59, wherein the method comprises:
   - attaching directly the optical element to the detector element to form a sub-assembly;
   - attaching the charged particle-optical element to the optical assembly; and
   - stacking the sub-assembly and the charged particle-optical element such that the optical element is positioned between the detector element and the charged particle-optical element.

### List of reference numerals:

100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
148 first multipole lens
150 controller
158 second multipole lens
201 source
202 source beam
204 electron-optical axis
207 sample holder
208 sample
209 actuatable stage
211, 212, 213 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
291 photon converter array
292 fluorescent strip
293 openings
295 deflector array
296 magnetic deflector
297 electrostatic deflector
298 optical fiber
299 electron-optical device array
50 assembly
300 charged particle optical device
301 array of apertures of charged particle-optical device
310 optical element
311 array of apertures of optical element
312 coupling surface of optical element
320 detector element
321 array of apertures or detector element
330 waveguide array
331 optical fibers
332 coupling surface of waveguide array
340 first dielectric supporting structure
350 second dielectric supporting structure
360, 361, 362, 363, 364, 365, 366, 367, 368 adhesive layers
332 stiffening element

## Claims

1. An optical assembly for a charged particle-optical device configured to project one or more charged particle beams towards a sample, wherein the optical assembly comprises:
a charged particle-optical element configured for passage of the one or more charged particle beams;
a detector element for detecting charged particles emitted from the sample in relation to the one or more charged particle beams;
an optical element configured to project optical radiation towards the sample,
wherein the optical element is configured to be positioned between the charged particle-optical element and the detector element and is further configured to be directly attached by adhesive to the charged particle-optical element or the detector element.

2. The optical assembly of claim 1, wherein the optical element defines at least one aperture for the passage therethrough of the one or more charged particle beams.

3. The optical assembly of claim 2, wherein the charged particle-optical element defines at least one aperture for the passage therethrough of the one or more charged particle beams.

4. The optical assembly of claim 3, wherein the at least one aperture of the charged particle-optical element is associated with the at least one aperture of the optical element for passage of the one or more charged particle beams.

5. The optical assembly of any one of claims 2 to 4, wherein the detector element comprises at least one aperture for the passage therethrough of the one or more charged particle beams.

6. The optical assembly of claim 5, wherein the at least one aperture of the detector element is associated with the at least one aperture of the optical element for passage of the one or more charged particle beams.

7. The optical assembly of any one of the preceding claims, further comprising a first dielectric supporting structure configured to support the said charged particle-optical element.

8. The optical assembly of claim 7, wherein the charged particle-optical element is positioned between the first dielectric supporting structure and the detector element.

9. The optical assembly of any one of the preceding claims, further comprising a waveguide array which is optically coupled to the optical element for providing optical radiation from an external source to the optical element.

10. The optical assembly of claim 9, wherein the waveguide array is positioned outside of a region defined between the first dielectric supporting structure and the detector element.

11. The optical assembly of any one of claims 9-10, further comprising a connector for attaching the waveguide array to another part of the assembly.

12. The optical assembly of any one of claims 9 to 11, wherein the optical element comprises a coupling surface and the waveguide array comprising a coupling surface, wherein the waveguide array is optically coupled to the optical element via the coupling surfaces, and wherein optical element and the waveguide array are connected, directly or indirectly, to define a gap between the coupling surfaces.

13. A method of providing an optical assembly of any one of claims 1 to 12, wherein the method comprises:
- attaching directly the optical element to the detector element to form a sub-assembly; and
- attaching the charged particle-optical element to the optical assembly; and
- stacking the sub-assembly and charged particle-optical element such that the optical element is positioned between the detector element and the charged particle-optical element.

14. A charged particle optical device configured to project one or more charged particle beams towards a sample, the charged particle-optical device comprising an optical assembly according to any one of claims 1 to 12.

15. The charged particle-optical device of claim 14, wherein a major surface of the detector element is a most downbeam surface of the charged particle-optical device, and wherein the major surface is configured to face the sample.
